# EUROPÄISCHE PATENTSCHRIFT

(11) **EP 1 173 895 B1**
(45) Veröffentlichungstag und Bekanntmachung des Hinweises auf die Patenterteilung: **21.01.2004**
(21) Anmeldenummer: 99957894.1
(22) Anmeldetag: 13.10.1999
(51) Int. Cl.: H01L 41/083, H01L 41/047

(54) **PIEZOELEKTRISCHER AKTOR**
PIEZOELECTRIC ACTUATOR
ACTIONNEUR PIEZOELECTRIQUE

(30) Priorität: 24.03.1999 DE 19913271
(43) Veröffentlichungstag der Anmeldung: 23.01.2002
(73) Patentinhaber: ROBERT BOSCH GMBH, 70442 Stuttgart (DE)
(72) Erfinder: HEINZ, Rudolf, D-71272 Renningen (DE); HENNEKEN, Lothar, D-71638 Ludwigsburg (DE)
(86) Internationale Anmeldenummer: PCT/DE1999/003283
(87) Internationale Veröffentlichungsnummer: WO 2000/057497

(56) Entgegenhaltungen:
- EP-A- 0 362 416
- US-A- 5 406 164
- PATENT ABSTRACTS OF JAPAN vol. 012, no. 435 (E-683), 16. November 1988 (1988-11-16) & JP 63 169777 A (MITSUBISHI ELECTRIC CORP), 13. Juli 1988 (1988-07-13)
- PATENT ABSTRACTS OF JAPAN vol. 012, no. 211 (E-622), 16. Juni 1988 (1988-06-16) & JP 63 009168 A (MITSUBISHI ELECTRIC CORP), 14. Januar 1988 (1988-01-14)
- PATENT ABSTRACTS OF JAPAN vol. 1995, no. 01, 28. Februar 1995 (1995-02-28) & JP 06 296048 A (BROTHER IND LTD), 21. Oktober 1994 (1994-10-21)

## Beschreibung

### Stand der Technik

Die Erfindung geht aus von einem piezoelektrischen Aktor nach der Gattung des Anspruchs 1. Ein piezoelektrischer Aktor zum Verstellen eines ultraschnellen Ventiles ist z. B. aus der DE 37 136 97 A1 bekannt.

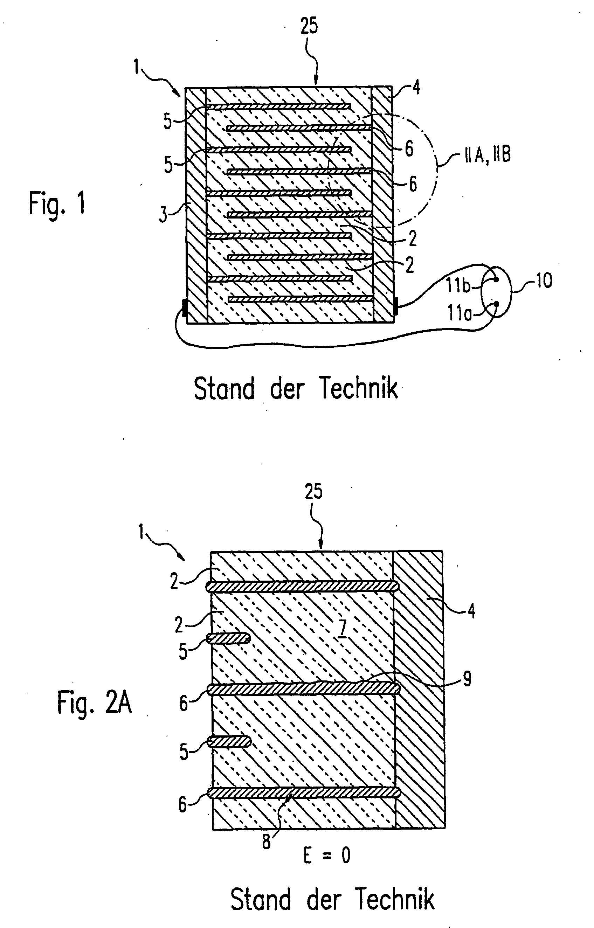

Fig. 1 zeigt einen im Stand der Technik bekannten piezoelektrischen Aktor 1 in Schnittansicht. Dabei besteht der piezoelektrische Aktor aus Scheiben 2 aus einem piezoelektrischen Material, die in Form eines Stapels 25 übereinander angeordnet sind. Zwischen den aufeinanderfolgenden Scheiben 2 aus piezoelektrischem Material sind jeweils Innenelektroden 5 bzw. 6 angeordnet. Die Innenelektroden 5 bzw. 6 kontaktieren wechselseitig auf der Außenseite des Stapels 25 der Scheiben 2 aus piezoelektrischem Material angeordnete Außenelektroden 3 bzw. 4. Die Außenelektroden 3 bzw. 4 sind jeweils mit einem Anschluß 11a bzw. 11b einer Steuerspannungsquelle 10 elektrisch verbunden. Die Innenelektroden 5 bzw. 6 sind somit über die Außenelektroden 3 bzw. 4 alternierend mit den Anschlüssen 11a bzw. 11b der Steuerspannungsquelle 10 verbunden.

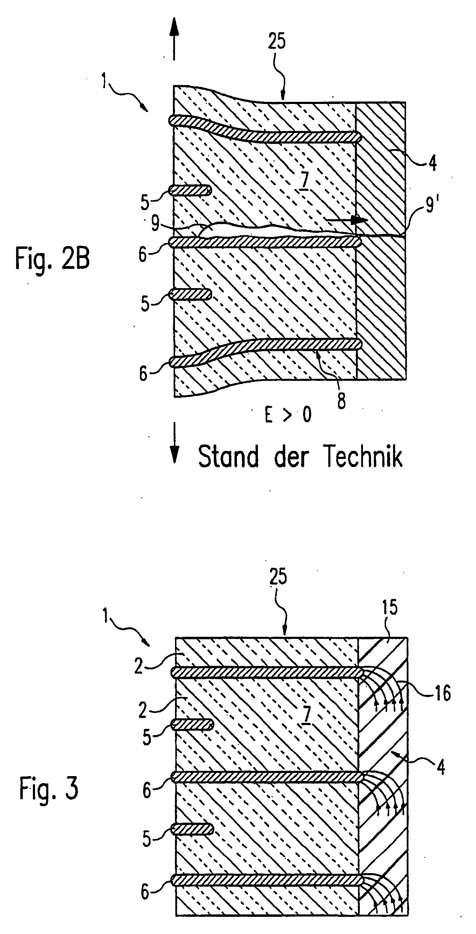

In Fig. 2A bzw. Fig. 2B ist der in Fig. 1 eingezeichnete kreisförmige Ausschnitt eines Randbereiches des piezoelektrischen Aktors 1 in vergrößerter Darstellung wiedergegeben. In dem vergrößert dargestellten Randbereich ist zu unterscheiden zwischen dem Bereich 7 und dem Bereich 8. In dem Bereich 7 ist die Innenelektrode 5 nicht bis zur Außenelektrode 4 durchkontaktiert und die Scheiben 2 aus piezoelektrischem Material sind in dem Bereich 7 durchgesintert. In dem Bereich 8 ist die Innenelektrode 6 mit der Außenelektrode 4 verbunden. Die Haftfestigkeit im Bereich 8 zwischen einer Scheibe 2 aus piezoelektrischem Material und einer Innenelektrode 6 ist um den Faktor 3 bis 5 kleiner als die Haftfestigkeit in dem Bereich 7 zwischen den durchgesinterten Scheiben 2 aus piezoelektrischem Material.

Fig. 2A zeigt dabei den Zustand des piezoelektrischen Aktors 1, ohne daß ein elektrisches Feld E angelegt ist. In Fig. 2B kommt es nach Beaufschlagung mit einer Steuerspannung aufgrund des piezoelektrischen Effektes im zentralen Bereich des Aktors 1 zu einer Dehnung. Im Randbereich 7, in dem keine entgegengesetzt gepolten Innenelektroden einander gegenüber angeordnet sind, sondern die Scheiben 2 aus piezoelektrischem Material durchgesintert sind, kommt es jedoch nicht zu einer piezoelektrischen Dehnung. Infolge der Dehnung im zentralen Bereich des piezoelektrischen Aktors 1 treten im Randbereich Zugspannungen auf, wobei es häufig zu Delaminationen 9 in dem Kontaktbereich zwischen den Innenelektroden 6 und den Scheiben 2 aus piezoelektrischem Material im Bereich 8 kommt.

Wie in Fig. 2B dargestellt, setzen sich diese Delaminationen 9 bis in den Bereich der Außenelektrode 4 fort. Ein solcher sich in die Außenelektrode 4 fortsetzender Riß 9' beeinträchtigt die Kontaktierung der Innenelektroden 6 erheblich. Sofern sich der Riß 9' durch die Außenelektrode 4 vollständig fortsetzt, wird der Kontakt in der Außenelektrode 4 unterbrochen und ein Teil der Innenelektroden 8 nicht mehr mit Spannung beaufschlagt. Dadurch wird die Gesamtdehnung bzw. der Hub des Aktors 1 erheblich verringert.

Um bei auftretenden Rissen 9' die Funktionsfähigkeit des Aktors 1 weiter zu gewährleisten, sind im Stand der Technik verschiedene Vorschläge gemacht worden.

### Vorteile der Erfindung

Der piezoelektrische Aktor mit den Merkmalen der Ansprüche 1 und 6 hat demgegenüber den Vorteil, daß die in. Form einer Beschichtung aus elektrisch leitfähigem Polymermaterial auf der Außenseite des Stapels aufgebrachten Außenelektroden elastisch sind oder dass das metallische Leitelement entlang ein Stapelrichtung eine sich verjüngende Breite aufweist. Die infolge einer Spannungsbeaufschlagung im Randbereich einer Außenelektrode auftretenden Zugspannungen werden von der elastischen Außenelektrode bei dem Aktor gemäß der vorliegenden Erfindung aufgenommen, ohne daß es zu Einrissen oder Abrissen in der Außenelektrode kommt. Ein ggf. zwischen Innenelektrode und einer Scheibe aus piezoelektrischem Material auftretender Riß wird folglich an der elastischen Außenelektrode aufgehalten. Ein mit elastischen Außenelektroden versehener piezoelektrischer Aktor löst auf einfache und zuverlässige Weise die bei piezoelektrischen Aktoren in den Außenelektroden auftretende Rißproblematik.

Äußerst vorteilhaft entfällt weiterhin das beim Herstellen eines herkömmlichen Aktors 1 bislang erforderliche Anätzen und Bekeimen der Aktoraußenfläche, was z. B. bei der Aufbringung einer Nickelaußenelektrode erforderlich ist. Bei dem im Stand der Technik erforderlichen Anätzen besteht immer die Gefahr des Unterätzens und eines nachfolgenden Ablösens der Außenelektrode im Betriebszustand des Aktors.

Durch die in den Unteransprüchen aufgeführten Maßnahmen sind vorteilhafte Weiterbildungen des im Anspruch 1 angegebenen piezoelektrischen Aktors möglich.

### Zeichnungen

Ausführungsbeispiele der Erfindung sind in der Zeichnung vereinfacht dargestellt und in der nachfolgenden Beschreibung näher erläutert. Es zeigen:
- Fig. 1: eine Schnittdarstellung eines im Stand der Technik bekannten piezoelektrischen Aktors,
- Fig. 2A: eine vergrößerte Schnittdarstellung des Ausschnitts IIA in Fig. 1, wobei an den Aktor kein elektrisches Feld E angelegt ist,
- Fig. 2B: eine vergrößerte Schnittdarstellung des Ausschnitts IIB in Fig. 1, wobei an den Aktor ein elektrisches Feld E (E > 0) angelegt ist,
- Fig. 3: eine Schnittdarstellung eines Randbereiches des erfindungsgemäßen piezoelektrischen Aktors mit einer Außenelektrode aus einem elastischen, elektrisch leitfähigen Polymermaterial,
- Fig. 4: eine Schnittdarstellung eines Randbereiches einer Ausführungsform des erfindungsgemäßen piezoelektrischen Aktors, wobei in dem elastischen, elektrisch leitfähigen Polymermaterial eine Siebelektrode angeordnet ist,
- Fig. 5: eine Schnittdarstellung eines Randbereiches einer Ausführungsform des erfindungsgemäßen piezoelektrischen Aktors, wobei die Innenelektroden in dem Kontaktbereich mit dem elastischen, elektrisch leitfähigen Polymermaterial zylinderförmige Kontakte aufweisen,
- Fig. 6: eine Schnittdarstellung eines Randbereiches einer Ausführungsform des erfindungsgemäßen piezoelektrischen Aktors, wobei auf dem elastischen, elektrisch leitfähigen Polymermaterial eine Wellelektrode aufgebracht ist,
- Fig. 7: eine Draufsicht auf eine Außenelektrode eines erfindungsgemäßen piezoelektrischen Aktors, wobei in dem elastischen, elektrisch leitfähigen Polymermaterial mehrere gewellte Drahtelektroden angeordnet sind,
- Fig. 8: eine Draufsicht auf eine Außenelektrode eines erfindungsgemäßen piezoelektrischen Aktors, wobei in dem elastischen, elektrisch leitfähigen Polymermaterial eine Siebelektrode mit konstanter Breite angeordnet ist,
- Fig. 9: eine Draufsicht auf eine Außenelektrode eines erfindungsgemäßen piezoelektrischen Aktors, wobei in dem elastischen, elektrisch leitfähigen Polymermaterial eine Siebelektrode mit einer Breite, die in eine Stapelrichtung abnimmt, angeordnet ist,
- Fig. 10: eine perspektivische Ansicht einer Außenelektrode eines erfindungsgemäßen piezoelektrischen Aktors, wobei das elastische, elektrisch leitfähige Polymermaterial über die gesamte Fläche eine konstante Dicke aufweist, und
- Fig. 11: eine perspektivische Ansicht einer Außenelektrode eines erfindungsgemäßen piezoelektrischen Aktors, wobei das elastische, elektrisch leitfähige Polymermaterial eine Dicke aufweist, die entlang einer Stapelrichtung abnimmt.

### Beschreibung der Ausführungsbeispiele

In Fig. 3 ist ein Ausschnitt eines Elektrodenrandbereiches eines piezoelektrischen Aktors 1 in Schnittdarstellung gemäß der vorliegenden Erfindung dargestellt. Die Innenelektroden 5 bzw. 6 sind in alternierender Weise angeordnet und jeweils durch eine Scheibe 2 aus piezoelektrischem Material getrennt. Die Innenelektroden 6 sind bei dem Ausführungsbeispiel gemäß Fig. 3 mit der Außenelektrode aus einem elastischen, elektrisch leitfähigem Polymermaterial 15 verbunden.

Als piezoelektrisches Material für die Scheiben 2 können z.B. Quarz, Turmalin, Bariumtitanat (BaTiO₃) oder aber auch spezielle Piezokeramiken wie beispielsweise ein Bleizirkonat-Bleititanatsystem (PZT-System) (PbZrO₃-PbTiO₃) eingesetzt werden. Gemäß der vorliegenden Erfindung kann jedes piezoelektrische Material wie beispielsweise auch ein organisches Salz wie Kalium- (Natrium) tartrat, Ethylendiamintartrat oder auch Polymere wie PVDF, PVF, etc. verwendet werden.

Als elastische, elektrisch leitfähige Polymere können sämtliche Polymere verwendet werden, die durch Zumischung von leitfähigen Füllstoffen elektrisch leitfähig werden.

Die Polymere können dabei mit leitfähigen Füllstoffen wie beispielsweise Ruß, Kohlenstofffasern, nickelbeschichtetem Glimmer, Stahlfasern, Aluminiumplättchen, Silberpulver, Silberflitter, Kupferpulver, Kupferflitter, Goldpulver oder goldbeschichtete Polymerkugeln versetzt werden, um den gewünschten Grad an elektrischer Leitfähigkeit zu erzeugen.

Die Polymere können aber auch Polymere mit einer intrinsischen elektrischen Leitfähigkeit wie beispielsweise cis- oder trans-Polyacetylen, Poly(p-phenylen), Polythiophen, Polypyrrol, etc. enthalten. Diese intrinsisch elektrisch leitfähigen Polymere können dann durch Behandeln mit starken Oxidations- oder Reduktionsmitteln wie beispielsweise Brom, Jod, Silberperchlorat, Bortrifluorid, Naphthalinnatrium, Arsenpentafluorid, etc. erhalten (dotiert) werden.

Im Sinne der Erfindung werden bevorzugt Siliconelastomere, die mit metallischen Füllstoffen wie beispielsweise Silber dotiert sind, verwendet. Weiterhin ist es bevorzugt, thermoplastische Copolymere als zu dotierendes Polymermaterial für die Außenelektrode zu verwenden.

Die Innenelektroden 5, 6 sind regelmäßig aus Metallen gefertigt, die einen Schmelzpunkt aufweisen, der oberhalb der Sintertemperatur der verwendeten piezoelektrischen Materialien liegt wie beispielsweise Platin, Silber, Kupfer, Silber-Palladiumlegierungen, etc.. Weiterhin können die Innenelektroden 5, 6 durch bekannte herkömmliche Verfahren wie Siebdrucktechnik, Sputtern, Aufdampfen, etc. auf die Scheiben 2 aus piezoelektrischem Material aufgebracht werden.

In Fig. 3 ist weiterhin der Stromlinienfluß in dem elastischen, elektrisch leitfähigen Polymer 15 zu der Innenelektrode 6 durch die Stromlinien 16 dargestellt. Der Anschluß der Außenelektrode 4 an die Steuerspannungsquelle 10 ist dabei nicht dargestellt.

Bei Verwendung von stegförmigen Innenelektroden, wie in Fig. 3 anhand der Innenelektroden 6 gezeigt; die in das elastische, elektrisch leitfähige Polymer 15 stegförmig hineinragen, wird die Stromdichte, die durch die Stromlinien 16 veranschaulicht ist, an den Innenelektroden 6 verringert. Dadurch werden vorteilhaft lokale Erwärmungen im Kontaktbereich zwischen der Innenelektrode 6 und dem elastischen, elektrisch leitfähigen Polymermaterial 15 verringert. Eine Vermeidung von hohen Temperaturen in dem vorgenannten Kontaktbereich bewirkt eine Verlängerung der Lebenszeit des Aktors, da vorzeitige Alterungserscheinungen bei dem Polymermaterial 15 vermieden werden.

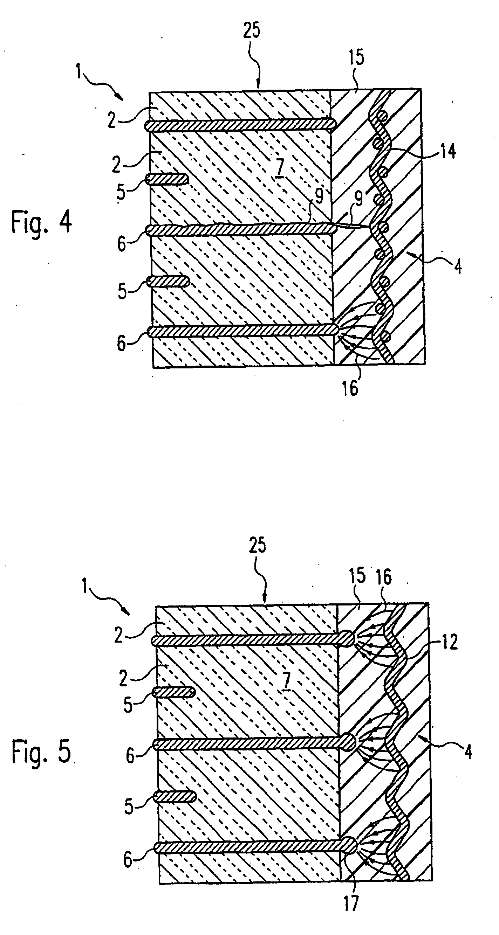

In Fig. 4 ist eine weitere vorteilhafte Ausführungsform der vorliegenden Erfindung gezeigt. Gemäß Fig. 4 ist in der elastischen, elektrisch leitfähigen Polymerschicht 15 eine Siebelektrode 14 vorgesehen. Sofern es zu einer Rißbildung 9' zwischen Innenelektrode 6 und einer Scheibe 2 aus piezoelektrischem Material gekommen ist und sich dieser Riß 9' in die Außenelektrode 4 aus dem elastischen, elektrisch leitfähigen Material 15 fortgesetzt haben sollte, so wird die Fortsetzung des Risses 9' an der Siebelektrode 14 gestoppt. Weiterhin erlaubt die erfindungsgemäße Ausführungsform gemäß Fig. 4 eine günstigere Führung der Stromlinien 16. Wie bereits zu der in Fig. 3 dargestellten Ausführungsform erläutert, werden so in Verbindung mit einer in das Polymermaterial 15 hineinragenden Stegelektrode 6 lokale Erwärmungen in dem Polymermaterial 15 vermieden, was letztendlich zu einer Lebenszeitverlängerung des piezoelektrischen Aktors 1 führt.

In Fig. 5 ist eine weitere bevorzugte Ausführungsform der vorliegenden Erfindung gezeigt. Die in das elastische, elektrisch leitfähige Polymermaterial 15 hineinragenden Innenelektroden 6 sind in dem Kontaktbereich mit dem Polymermaterial 15 mit zylinderförmigen Kontakten 17 versehen. Diese zylinderförmigen Kontakte 17 erlauben, bedingt durch die Oberflächenvergrößerung, eine weitere Herabsetzung des an der Innenelektrode 6 pro Flächeneinheit anliegenden Stromflusses (Herabsetzung der Stromdichte). Durch die zusätzliche Anordnung eines metallischen Leiters, wie der in Fig. 5 beispielhaft gezeigten Wellelektrode 12, kann die Stromlinienführung weiter verbessert werden. Anstelle der Kugelkontakte 17 können jedoch auch weitere Mittel zur Oberflächenvergrößerung an den in das elastische, leitfähige Polymermaterial 15 hineinragenden Innenektroden 6 vorgesehen sein, die nicht zylinderförmig sind, wie beispielsweise knöpfchenartige, kegelartige, pilzartige oder scheibenartige Aufsätze.

Die in Fig. 4 dargestellten stegartig bzw. in Fig. 5 zylinder- oder knöpfchenartig in das elastische, elektrisch leitfähige Polymermaterial 15 hineinragenden Innenelektroden 6 können beispielsweise durch gezielten elektrochemischen Aufbau hergestellt werden. Dabei wird der Stapel 25 aus Scheiben 2 aus piezoelektrischem Material und jeweils zwischen benachbarten Scheiben 2 aufgebrachten Innenelektroden 6 in einer Halterung fixiert und die aufzubauenden Innenelektroden 6, beispielsweise auf der der aufzubauenden Seite des Aktors 1 gegenüberliegenden Seite elektrisch kontaktiert und in einem Elektrolysebad unter Abscheidung eines Metalls gezielt aufgebaut.

Es ist natürlich auch möglich, die überstehenden Enden der Innenelektroden 6 unter Verwendung bekannter fotolithographischer Verfahren herzustellen. Dabei wird zunächst auf der Seitenfläche des Aktors 1, an der die Innenelektroden 6 überstehen sollen, eine Maske mit einem entsprechenden Raster aufgebracht. Nach dem gezielten Abscheiden des die Innenelektroden 6 aufbauenden Metalles wird der die Maske aufbauende Film auf herkömmliche Weise aufgelöst. Auf die so hergestellten überstehenden Enden der Innenelektrode 6 wird dann das elastische, elektrisch leitfähige Polymermaterial 15 aufgebracht, das wahlweise ein weiteres metallisches Leitelement enthalten kann.

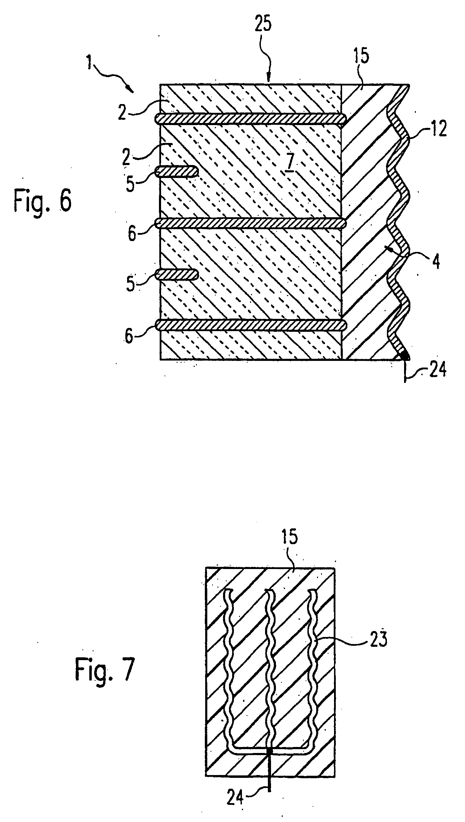

In Fig. 6 ist ein Ausschnitt eines Elektrodenrandbereiches eines weiteren Aktors 1 gemäß der vorliegenden Erfindung gezeigt. Das elastische, elektrisch leitfähige Polymermaterial 15 ist in Kontakt mit den seitlich an der Aktoraußenseite hervorstehenden Innenelektroden 6. Auf das elastische, elektrisch leitfähige Polymermaterial 15 ist eine Wellelektrode 12 aufgebracht. Die Außenelektrode 4 ist dann über einen Anschlußkontakt 24 mit der Steuerspannungsquelle 10 elektrisch verbunden, die nicht dargestellt ist.

Eine weitere beispielhafte Anordnung von metallischen Leitelementen in dem elastischen, elektrisch leitfähigem Polymermaterial 15 ist in Fig. 7 gezeigt.

Fig. 7 zeigt eine Draufsicht auf eine entlang einer Stapelaußenseite eines piezoelektrischen Aktors 1 aufgebrachte Außenelektrode 4, wobei in dem elastischen, elektrisch leitfähigem Polymermaterial 15 eine oder mehrere Drahtelektroden 23 eingebettet sind.

Es ist selbstverständlich, daß das in das elastische, elektrisch leitfähige Polymermaterial 15 eingebettete metallische Leitelement verschiedenartige geometrische Ausprägungen haben kann, wie beispielsweise als Wellblech, Draht oder Welldraht, Streckmetall, Spiralfeder, etc.

Wesentlich ist bei einer zusätzlichen Anordnung eines metallischen Leitelements in dem elastisch, elektrisch leitfähigem Polymermaterial 15, daß das metallische Leitelement keinen direkten Kontakt mit den beispielsweise in das elastische, elektrisch leitfähige Polymermaterial 15 stegförmig hineinragenden Innenelektroden 5, 6 hat. Insofern wird der elektrische Kontakt zwischen metallischem Leitelement und den Innelektroden 5, 6 ausschließlich über das elastische, elektrisch leitfähige Polymermaterial 15 bewirkt.

Die Einbringung eines metallischen Leitelementes in das elastische, elektrisch leitfähige Polymermaterial 15 bewirkt u. a., daß, wie vorstehend ausgeführt, die Stromlinienführung, wie in den Fig. 4 und Fig. 5 beispielhaft dargestellt, günstiger ist und insofern lokale Überhitzungen an der Kontaktstelle zwischen Innenelektrode 6 und dem elastischen, elektrisch leitfähigem Polymermaterial 15 vermieden werden. Insofern werden vorzeitige Alterungserscheinungen bei dem elastischen, elektrisch leitfähigem Polymermaterial 15 vermieden. Weiterhin bewirkt die Einbringung eines metallischen Leitelements, daß die Dicke des aufgebrachten elastischen, elektrisch leitfähigen Polymermaterials 15 verringert werden kann. Schließlich werden äußerst vorteilhaft an dem metallischen Leitelement sich gegebenenfalls in das Polymermaterial 15 fortsetzende Risse 9' gestoppt.

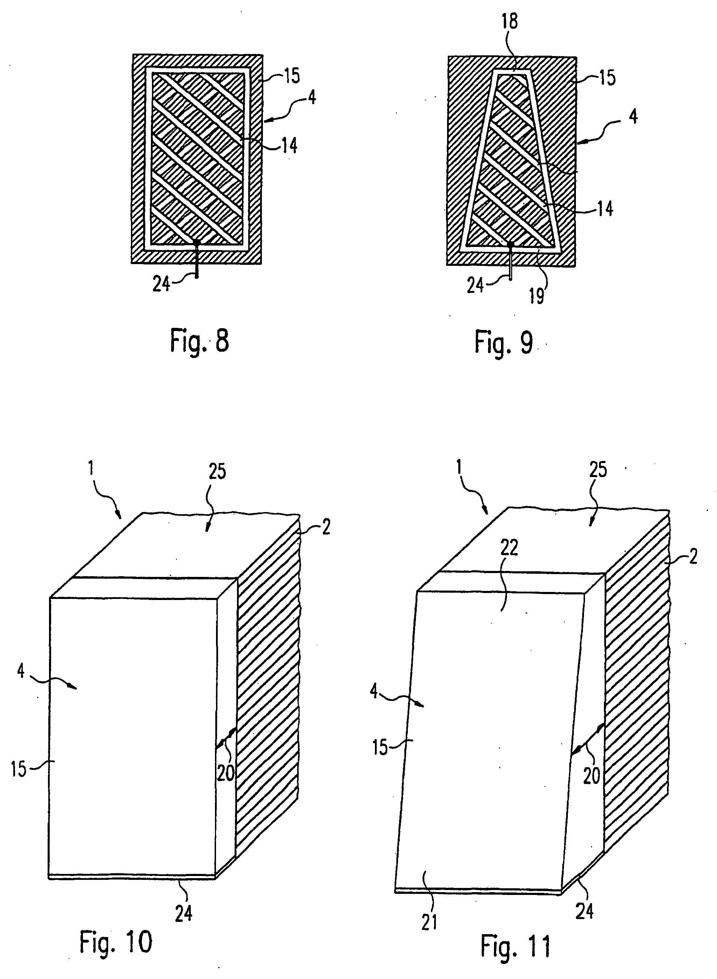

In Fig. 8 ist eine Draufsicht auf eine entlang einer Stapelrichtung an der Außenseite des Stapels 25 aufgebrachte Außenelektrode 4 gezeigt, wobei in das elastische, elektrisch leitfähige Polymermaterial 15 eine Siebelektrode 14 eingebettet ist. Die Siebelektrode 14 weist entlang der Stapelaußenseite des Aktors 1 eine konstante Breite auf. Der elektrische Kontakt mit der Steuerspannungsquelle 10 erfolgt über den elektrischen Anschlußkontakt 24.

In Fig. 9 ist eine Draufsicht auf eine Außenelektrode 4 gezeigt, die der von Fig. 8 entspricht. Im Unterschied zu Fig. 8 weist das in das elastische, elektrisch leitfähige Polymermaterial 15 eingebettete elektrische Leitelement in Form einer Siebelektrode 14 eine entlang einer Stapelrichtung an der Außenseite des Stapels 25 der Scheiben 2 aus piezoelektrischem Material abnehmende Breite auf. Der elektrische Kontakt mit der Steuerspannungsquelle 10 wird über den elektrischen Anschlußkontakt 24 an dem breiten Ende 19 der Siebelektrode 14 hergestellt. Diese trapezförmige Ausgestaltung der Form der Siebelektrode 14 trägt dem Umstand Rechnung, daß die Stromdichte an dem dem elektrischen Anschlußkontakt 24 abweisenden schmalen Ende 18 der Siebelektrode 14 kleiner sein kann. Die in Fig. 9 dargestellte beispielhafte trapezförmige Ausgestaltung des metallischen Leitelements erlaubt äußerst vorteilhaft eine Einsparung des möglicherweise kostenintensiven metallischen Elektrodenmaterials. Selbstverständlich kann das in Fig. 9 beispielhaft gezeigte metallische Leitelement auch massiv wie beispielsweise in Form einer Wellelektrode aus einem Wellblech gebildet sein.

Fig. 10 zeigt eine perspektivische Ansicht einer entlang einer Stapelrichtung an der Außenseite des Stapels 25 der Scheiben 2 aus piezoelektrischem Material aufgebrachten Außenelektrode 4 aus einem elastischen, elektrisch leitfähigem Polymermaterial 15. Das elastische, elektrisch leitfähige Polymermaterial 15 weist dabei über die gesamte Länge und Breite eine konstante Dicke 20 auf. Das elastische, elektrisch leitfähige Polymermaterial 15 ist über den elektrischen Anschlußkontakt 24 mit der Steuerspannungsquelle 10 verbunden.

Fig. 11 zeigt eine perspektivische Ansicht einer Außenelektrode 4, die weitgehend der von Fig. 10 entspricht, wobei jedoch die Dicke 20 des elastischen, elektrisch leitfähigen Polymermaterials 15 entlang einer Stapelrichtung abnimmt. Dabei ist die Steuerspannungsquelle 10 über den elektrischen Anschlußkontakt 24 mit dem dicken Ende 21 des elastischen, elektrisch leitfähigen Polymermateriales 15 verbunden. Wie bereits oben zu Fig. 9 angemerkt, ist die Stromdichte an der dem elektrischen Anschlußkontakt 24 abgewandten Seite, d. h. an dem dünnen Ende 22 des elastischen, elektrisch leitfähigem Polymermaterials 15 geringer. Eine gemäß Fig. 11 ausgestaltete Außenelektrode erlaubt vorteilhaft die Einsparung von elastischem, elektrisch leitfähigem Polymermaterial 15 und somit eine kostengünstigere Herstellung des erfindungsgemäßen Aktors 1.

selbstverständlich können beispielsweise die in Fig. 9 und Fig. 11 dargestellten beispielhaften Ausführungsformen der vorliegenden Erfindung auch miteinander kombiniert werden, so daß die Dicke des elastischen, elektrisch leitfähigem Polymermaterials 15 entlang der Stapelrichtung an der Außenseite des Stapels der Scheiben 2 aus piezoelektrischem Material abnimmt, in der auch die Breite eines in dem elastischen, elektrisch leitfähigem Polymermaterial 15 angeordneten metallischen Leitelementes abnimmt. Die Steuerspannungsquelle 10 ist dann sowohl mit dem dicken Ende 21 des elastischen, elektrisch leitfähigen Polymermaterials 15 als auch mit dem breiten Ende 19 beispielsweise einer eingebetteten Siebelektrode 14 elektrisch verbunden. Durch diese äußerst vorteilhafte Kombination ist es möglich, sowohl Elektrodenmaterial als auch Polymermaterial 15 einzusparen. Weiterhin sind selbstverständlich auch weitere Kombinationen der in den Fig. 8 bis 11 dargestellten Ausführungsformen möglich.

Des weiteren werden von der vorliegenden Erfindung auch andere geometrische Grundformen wie beispielsweise Aktoren mit einer hexagonalen oder octagonalen Grundfläche etc. erfaßt, an deren Stapelaußenseite Außenelektroden 4 aus einem elastischen, elektrisch leitfähigen Polymermaterial 15 mit oder ohne eingebettetem oder aufgebrachtem metallischen Leiter angeordnet sind.

Der erfindungsgemäße piezoelektrische Aktor 1 kann vorteilhaft als Stellglied verwendet werden. Insbesondere ist der erfindungsgemäße piezoelektrische Aktor 1 in Benzindirekteinspritzsystemen und in Dieseleinspritzsystemen wie Common-Rail-Einspritzsystemen oder Unit-Injection-Systemen (Pumpendüseneinheiten) verwendbar.

## Patentansprüche

1. Piezoelektrischer Aktor (1) mit
- einer Vielzahl von Scheiben (2) aus piezoelektrischem Material, die zu einem Stapel (25) in einer Stapelrichtung angeordnet sind,
- einer Vielzahl von flächigen Innenelektroden (5, 6), die mit den Scheiben (2) aus piezoelektrischem Material alternierend angeordnet sind,
- wenigstens zwei entlang der Stapelrichtung an der Außenseite des Stapels (25) aufgebrachten Außenelektroden (3, 4), wobei die Innenelektroden (5, 6) alternierend mit jeweils einer der Außenelektroden (3, 4) über einen Kontaktbereich verbunden sind und wobei die Außenelektroden (3, 4) in Form einer Beschichtung aus einem elastischen, elektrisch leitfähigen Polymermaterial (15) auf der Außenseite des Stapels (25) aufgebracht sind,
**dadurch gekennzeichnet,**
**daß** die Beschichtung aus dem elastischen, elektrisch leitfähigen Polymermaterial (15) eine entlang einer Stapelrichtung abnehmende Dicke aufweist, wobei eine Steuerspannungsquelle (10) mit dem dicken Ende (21) der Beschichtung verbindbar ist.

2. Piezoelektrischer Aktor nach Anspruch 1,
**dadurch gekennzeichnet,**
**daß** das piezoelektrische Material ein Bleizirkonat-Bleititanat-System (PZT-System) ist.

3. Piezoelektrischer Aktor nach Anspruch 1 oder 2,
**dadurch gekennzeichnet,**
**daß** das elastische, elektrisch leitfähige Polymermaterial (15) mit metallischem Füllstoff dotiert ist.

4. Piezoelektrischer Aktor nach einem der Ansprüche 1 bis 3,
**dadurch gekennzeichnet,**
**daß** in oder an dem als Beschichtung aufgebrachten elastischen, elektrisch leitfähigen Polymermaterial (15) wenigstens ein metallisches Leitelement (12, 14, 23) vorgesehen ist.

5. Piezoelektrischer Aktor nach Anspruch 4,
**dadurch gekennzeichnet,**
**daß** das metallische Leitelement (14) entlang einer Stapelrichtung eine sich verjüngende Breite aufweist, wobei die Steuerspannungsquelle (10) mit dem breiten Ende (19) des metallischen Leitelements (14) verbindbar ist.

6. Piezoelektrischer Aktor (1) mit
- einer Vielzahl von Scheiben (2) aus piezoelektrischem Material, die zu einem Stapel (25) in einer Stapelrichtung angeordnet sind,
- einer Vielzahl von flächigen Innenelektroden (5, 6), die mit den Scheiben (2) aus piezoelektrischem Material alternierend angeordnet sind,
- wenigstens zwei entlang der Stapelrichtung an der Außenseite des Stapels (25) aufgebrachten Außenelektroden (3, 4), wobei die Innenelektroden (5, 6) alternierend mit jeweils einer der Außenelektroden (3, 4) über einen Kontaktbereich verbunden sind und wobei die Außenelektroden (3, 4) in Form einer Beschichtung aus einem elastischen, elektrisch leitfähigen Polymermaterial (15) auf der Außenseite des Stapels (25) aufgebracht sind, und
- wenigstens einem metallischen Leitelement (12, 14, 23), das in oder an dem als Beschichtung aufgebrachten elastischen, elektrisch leitfähigen Polymermaterial (15) vorgesehen ist,
**dadurch gekennzeichnet,**
**daß** das metallische Leitelement (14) entlang einer Stapelrichtung eine sich verjüngende Breite aufweist, wobei eine Steuerspannungsquelle (10) mit dem breiten Ende (19) des metallischen Leitelements (14) verbindbar ist.

7. Piezoelektrischer Aktor nach Anspruch 6,
**dadurch gekennzeichnet,**
**daß** das metallische Leitelement (14) trapezförmig ausgestaltet ist.

8. Piezoelektrischer Aktor nach Anspruch 6 oder 7,
**dadurch gekennzeichnet,**
**daß** das piezoelektrische Material ein Bleizirkonat-Bleititanat-System (PZT-System) ist.

9. Piezoelektrischer Aktor nach Anspruch 6, 7 oder 8,
**dadurch gekennzeichnet,**
**daß** das elastische, elektrisch leitfähige Polymermaterial (15) mit metallischem Füllstoff dotiert ist.

10. Piezoelektrischer Aktor nach Anspruch 6,
**dadurch gekennzeichnet,**
**daß** die Beschichtung aus dem elastischen, elektrisch leitfähigen Polymermaterial (15) eine entlang einer Stapelrichtung abnehmende Dicke aufweist, wobei die Steuerspannungsquelle (10) mit dem dicken Ende (21) der Beschichtung verbindbar ist.

11. Piezoelektrischer Aktor nach einem der Ansprüche 1 bis 10,
**dadurch gekennzeichnet,**
**daß** die Fläche des Kontaktbereichs zwischen Innenelektrode (5, 6) und Außenelektrode (3, 4) durch Anordnung von Mitteln (17) zur Oberflächenvergrößerung vergrößert ist.

## Claims

1. Piezoelectric actuator (1) with
- a multiplicity of plates (2) of piezoelectric material, which are arranged in a stacking direction to form a stack (25),
- a multiplicity of sheet-like internal electrodes (5, 6), which are arranged alternately with the plates (2) of piezoelectric material,
- at least two external electrodes (3, 4) applied to the outer side of the stack (25) along the stacking direction, the internal electrodes (5, 6) being connected alternately in each case to one of the external electrodes (3, 4) via a contact region, and the external electrodes (3, 4) being applied on the outer side of the stack (25) in the form of a coating of an elastic, electrically conductive polymer material (15),
**characterized in that** the coating of the elastic, electrically conductive polymer material (15) has a thickness which decreases along a stacking direction, a control voltage source (10) being able to be connected to the thick end (21) of the coating.

2. Piezoelectric actuator according to Claim 1, **characterized in that** the piezoelectric material is a lead zirconate/lead titanate system (PZT system).

3. Piezoelectric actuator according to Claim 1 or 2, **characterized in that** the elastic, electrically conductive polymer material (15) is doped with metallic filler.

4. Piezoelectric actuator according to one of Claims 1 to 3, **characterized in that** at least one metallic conducting element (12, 14, 23) is provided in or on the elastic, electrically conductive polymer material (15) applied as a coating.

5. Piezoelectric actuator according to Claim 4, **characterized in that** the metallic conducting element (14) has a tapering width along a stacking direction, the control voltage source (10) being able to be connected to the wide end (19) of the metallic conducting element (14).

6. Piezoelectric actuator (1) with
- a multiplicity of plates (2) of piezoelectric material, which are arranged in a stacking direction to form a stack (25),
- a multiplicity of sheet-like internal electrodes (5, 6), which are arranged alternately with the plates (2) of piezoelectric material,
- at least two external electrodes (3, 4) applied to the outer side of the stack (25) along the stacking direction, the internal electrodes (5, 6) being connected alternately in each case to one of the external electrodes (3, 4) via a contact region, and the external electrodes (3, 4) being applied on the outer side of the stack (25) in the form of a coating of an elastic, electrically conductive polymer material (15), and
- at least one metallic conducting element (12, 14, 23), which is provided in or on the elastic, electrically conductive polymer material (15) applied as a coating,
**characterized in that** the metallic conducting element (14) has a tapering width along a stacking direction, a control voltage source (10) being able to be connected to the wide end (19) of the metallic conducting element (14).

7. Piezoelectric actuator according to Claim 6, **characterized in that** the metallic conducting element (14) is trapezoidally shaped.

8. Piezoelectric actuator according to Claim 6 or 7, **characterized in that** the piezoelectric material is a lead zirconate/lead titanate system (PZT system).

9. Piezoelectric actuator according to Claim 6, 7 or 8, **characterized in that** the elastic, electrically conductive polymer material (15) is doped with metallic filler.

10. Piezoelectric actuator according to Claim 6, **characterized in that** the coating of the elastic, electrically conductive polymer material (15) has a thickness which decreases along a stacking direction, the control voltage source (10) being able to be connected to the thick end (21) of the coating.

11. Piezoelectric actuator according to one of Claims 1 to 10, **characterized in that** the surface of the contact region between the internal electrode (5, 6) and the external electrode (3, 4) is enlarged by arranging means (17) for surface enlargement.

## Revendications

1. Actionneur piézo-électrique (1), dans lequel :
- un certain nombre de disques (2) en matériau piézo-électrique sont superposés pour former une pile (25),
- un certain nombre d'électrodes internes plates (5, 6) sont montées en alternance avec les disques (2) en matériau piézoélectrique,
- au moins deux électrodes externes (3, 4) sont disposées sur la surface externe de la pile (25) dans la direction d'empilement, et reliées alternativement aux électrodes internes (5, 6),
- les électrodes (3, 4) sont déposées sur la surface externe de la pile (25) sous la forme d'un revêtement en matériau polymère (15), élastique et conducteur de l'électricité,
**caractérisé en ce que** le revêtement en matériau polymère (15) élastique et conducteur présente une épaisseur qui va en décroissant selon la direction d'empilement et une source de tension de commande (10) peut être reliée à l'extrémité épaisse (21) du revêtement.

2. Actionneur piézo-électrique selon la revendication 1, **caractérisé en ce que** le matériau piézo-électrique est un système zirconate de plomb/titanate de plomb (système PZT)

3. Actionneur piézo-électrique selon l'une quelconque des revendications 1 ou 2, **caractérisé en ce que** le matériau polymère (15), élastique et conducteur, est dopé par une charge métallique.

4. Actionneur piézo-électrique selon l'une quelconque des revendications 1 à 3, **caractérisé en ce qu'**il est prévu dans ou sur le matériau polymère (15) constituant le revêtement, au moins un élément conducteur métallique (12, 14, 23).

5. Actionneur piézo-électrique selon la revendication 4,**caractérisé en ce que** l'élément conducteur métallique (14) présente une largeur qui va en diminuant selon la direction d'empilage, la source de tension de commande (10) pouvant être reliée à l'extrémité large (19) de l'élément conducteur métallique (14).

6. Actionneur piézo-électrique (1), dans lequel :
- un certain nombre de disques (2) en matériau piézo-électrique sont superposés pour former une pile (25),
- un certain nombre d'électrodes internes plates (5, 6) sont montées en alternance avec les disques (2) en matériau piézoélectrique,
- au moins deux électrodes externes (3, 4) sont disposées sur la surface externe de la pile (25) dans la direction d'empilement, et reliées alternativement aux électrodes internes (5, 6),
- les électrodes (3, 4) sont déposées sur la surface externe de la pile (25) sous la forme d'un revêtement en matériau polymère (15), élastique et conducteur de l'électricité,
- au moins un élément conducteur métallique (12, 14, 23) est prévu sur ou dans le revêtement en matériau polymère (15), élastique et conducteur, **caractérisé en ce que** l'élément conducteur métallique (14) présente une largeur qui va en diminuant selon la direction d'empilage, la source de tension de commande (10) pouvant être reliée à l'extrémité large (19) de l'élément conducteur métallique (14).

7. Actionneur piézo-électrique selon la revendication 6, **caractérisé en ce que** l'élément conducteur métallique (14) a la forme d'un trapèze.

8. Actionneur piézo-électrique selon l'une quelconque des revendications 6 ou 7, **caractérisé en ce que** le matériau piézo-électrique est un système zirconate de plomb titanate de plomb (système PZT).

9. Actionneur piézo-électrique selon l'une quelconque des revendications 6, 7 ou 8, **caractérisé en ce que** le matériau polymère (15), élastique et conducteur, est dopé par une charge métallique.

10. Actionneur piézo-électrique selon la revendication 6, **caractérisé en ce que** le revêtement en matériau polymère (15) élastique et conducteur présente une épaisseur qui va en décroissant selon la direction d'empilement et une source de tension de commande (10) peut être reliée à l'extrémité épaisse (21) du revêtement.

11. Actionneur piézo-électrique selon l'une quelconque des revendications 1 à 10, **caractérisé en ce que** la surface de la zone de contact entre l'électrode interne (5, 6) et l'électrode externe (3, 4) est accrue par la présence de moyens (17) d'augmentation de surface.
